# FASCICULE DE BREVET EUROPEEN

(11) **EP 0 639 001 B1**
(45) Date de publication et mention de la délivrance du brevet: **27.12.2000**
(21) Numéro de dépôt: 94401770.6
(22) Date de dépôt: 01.08.1994
(51) Int. Cl.: H03K 5/01, H03K 5/13

(54) **Circuit de filtrage d'un signal impulsionnel et circuit intégré comportant un tel circuit**
Impulssignalfilterschaltung und integrierte Schaltung zur Herstellung einer solchen Schaltung
Pulse signal filter circuit and integrated circuit with such a circuit

(30) Priorité: 05.08.1993 FR 9309680
(43) Date de publication de la demande: 15.02.1995
(73) Titulaire: STMicroelectronics S.A., 94250 Gentilly (FR)
(72) Inventeur: Wuidart, Sylvie, F-94230 Cachan (FR); Do, Tien-Dung, F-94230 Cachan (FR)
(74) Mandataire: Schmit, Christian Norbert Marie

(56) Documents cités:
- EP-A- 0 309 849
- EP-A- 0 514 714
- US-A- 5 130 582
- FUNKSCHAU, vol.50, no.12, Juin 1978, MUNCHEN DE page 578 H. GLÜNDER 'Schaltung zur Kontaktenprellung'
- ELECTRONIC DESIGN, vol.29, no.12, Juin 1981, HASBROUCK HEIGHTS, NEW JERSEY US pages 249 - 250 ROGER BAILEY 'recondition logic transitions to remove undesired random pulses'

## Description

La présente invention concerne un circuit de filtrage d'un signal impulsionnel. Elle trouve une application particulière dans les cartes à puce, notamment pour le filtrage du signal d'horloge.

L'invention concerne tout particulièrement les circuits nécessitant un signal impulsionnel dont les états haut et bas des impulsions sont stables pendant une durée minimale fixée. C'est notamment le cas des circuits destinés aux cartes à puces telles que cartes de crédit, ou de téléphone, pour lesquelles il est impératif de prévenir et empêcher toute fraude. Or, sans filtrage efficace et fiable du signal d'horloge appliqué à une carte à puce, un fraudeur pourrait parasiter ce signal d'horloge externe avec des impulsions de durées très courtes qui, si elles étaient prises en compte en interne par le circuit, pourraient par exemple permettre au fraudeur l'accès à des fonctions non autorisées.

Pour effectuer de tels filtrages, il est connu d'utiliser des circuits à verrouillage de phase avec filtre basse fréquence. Ces circuits sont cependant complexes et nécessitent le plus souvent des composants discrets, notamment pour la réalisation du filtre basse fréquence. Leur fonctionnement est fiable pour des caractéristiques du signal d'entrée bien délimitées à l'intérieur d'une zone spécifiée restreinte. En dehors de cette zone, la fiabilité n'est plus assurée.

Pour résoudre ces problèmes techniques, l'invention propose un circuit de filtrage d'un signal impulsionnel qui délivre en sortie un signal impulsionnel dont les états haut et bas des impulsions ont une durée minimale garantie, indépendante des caractéristiques du signal d'entrée. Les documents FUNKSCHAU, vol. 50, no. 12, Juin 1978, page 578, "Schaltung zur Kontaktentprellung" et ELECTRONIC DESIGN, vol. 29, no. 12, Juin 1981, pages 249-250, "recondition logic transitions to remove undesired random pulses" décrivent des circuits de filtrage avec deux circuits de retard.

Selon l'invention, la génération d'une impulsion de sortie est commandée par la détection d'une impulsion d'entrée, et la forme de l'impulsion de sortie est basée sur des délais élémentaires obtenus par la charge de capacités. Pendant toute la durée des délais élémentaires, aucune impulsion d'entrée ne peut être prise en compte.

Telle qu'elle est caractérisée, l'invention concerne un circuit de filtrage d'un signal impulsionnel d'entrée. Selon l'invention, ce circuit de filtrage comporte :
- un étage de génération d'un premier délai comprenant un premier condensateur dont la charge et la décharge sont contrôlées par un premier signal de commande, l'une des bornes de la capacité étant connectée à un détecteur de niveau non inverseur pour délivrer un premier signal de délai, l'autre borne étant reliée à la masse;
- un étage de génération d'un deuxième délai comprenant un deuxième condensateur dont la charge et la décharge sont contrôlées par un deuxième signal de commande, l'une des bornes du condensateur étant connectée à un deuxième détecteur de niveau non inverseur, pour délivrer un deuxième signal de délai, l'autre borne étant reliée à la masse;
- une première porte logique 1 de type OU recevant en entrée le premier signal de commande et le premier signal de délai et délivrant en sortie le deuxième signal de commande qui est aussi le signal impulsionnel de sortie;
- une deuxième porte logique 2 de type OU recevant en entrée le signal impulsionnel d'entrée, le signal impulsionnel de sortie et un signal de blocage commandé par le deuxième signal de délai et délivrant en sortie le premier signal de commande.

Avantageusement, la charge est effectuée à courant constant.

De préférence, pour que la décharge du premier condensateur soit complète avant la prise en compte d'une nouvelle impulsion du signal impulsionnel d'entrée, une bascule RS est placée en sortie de la deuxième porte logique pour délivrer le premier signal de commande. De cette manière, une impulsion trop courte en sortie de la deuxième porte logique ne sera pas prise en compte par la bascule, empêchant ainsi la prise en compte d'une nouvelle impulsion sur le signal impulsionnel d'entrée.

Le circuit de filtrage est avantageusement inclus dans un circuit intégré, et comporte en outre des moyens logiques pour empêcher la consommation de courant pendant les périodes où le signal impulsionnel de sortie n'est pas nécessaire pour le fonctionnement du circuit intégré.

D'autres avantages et caractéristiques de l'invention sont détaillés dans la description suivante, faite à titre indicatif et non limitatif de l'invention et en référence aux dessins annexés dans lesquels :
- la figure 1 est un schéma électronique d'un circuit de filtrage selon l'invention ;
- la figure 2 est un schéma électronique d'un circuit intégré comprenant un circuit de filtrage selon l'invention;
- la figure 3 est un chronogramme des différents signaux de la figure 2.

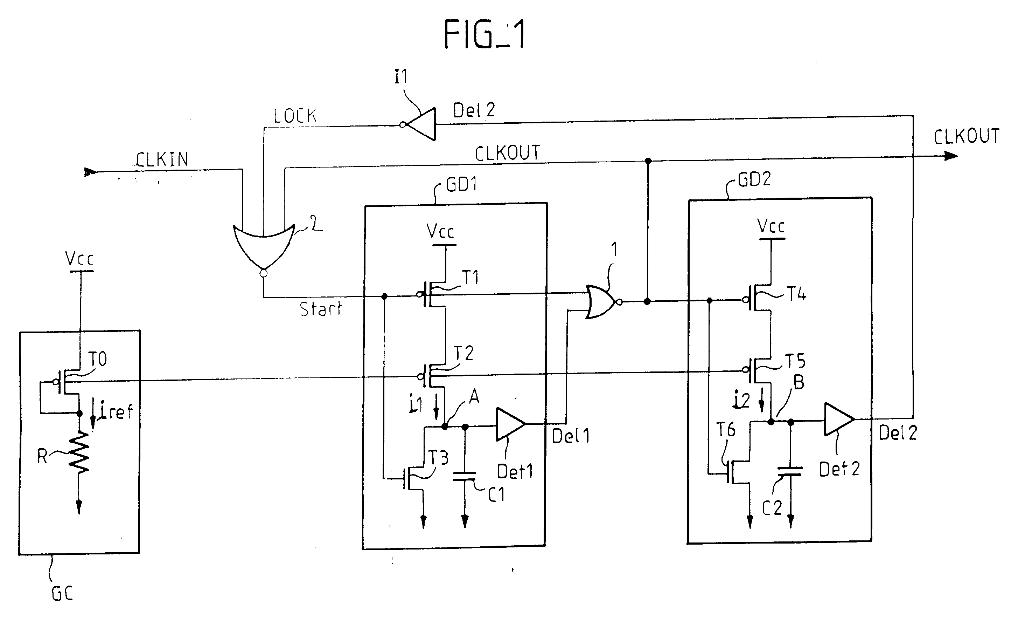

Un circuit de filtrage selon l'invention comprend, comme représenté en figure 1 :
- un étage de génération GD1 d'un premier délai d1 comprenant un premier condensateur C1 dont la charge et la décharge sont contrôlées par un premier signal de commande Start, l'une des bornes du condensateur étant connectée à un premier détecteur Det1 de niveau non inverseur, pour délivrer un premier signal de délai Del1, l'autre borne étant reliée à la masse;
- un étage de génération GD2 d'un deuxième délai d2 comprenant un deuxième condensateur C2 dont la charge et la décharge sont contrôlées par un deuxième signal de commande CLKOUT, l'une des bornes du condensateur étant reliée à un deuxième détecteur Det2 de niveau non inverseur, pour délivrer un deuxième signal de délai Del2, l'autre borne étant reliée à la masse;
- une première porte logique 1 de type OU recevant en entrée le premier signal de commande Start et le premier signal de délai Del1 et délivrant le deuxième signal de commande CLKOUT qui est aussi le signal impulsionnel de sortie;
- une deuxième porte logique 2 de type OU recevant en entrée le signal impulsionnel d'entrée CLKIN, le signal impulsionnel de sortie CLKOUT et un signal de blocage LOCK commandé par le deuxième signal de délai Del2, et délivrant en sortie le premier signal de commande Start.

Dans l'exemple de la figure 1 où on travaille en logique positive (état haut) et où les signaux de commande Start et CLKOUT commandent, comme on va le voir dans la suite, des transistors MOS de type P, les portes logiques 1 et 2 sont des portes NON OU et le signal de blocage LOCK est l'inverse du deuxième signal de délai Del2, obtenu par une porte inverseuse I1.

Le principe général de fonctionnement va maintenant être expliqué, avec la logique retenue dans l'exemple de la figure 1 (portes NON OU). On suppose comme conditions de départ que le condensateur C1 est déchargé et que les entrées CLKIN, CLKOUT et LOCK (/Del2) de la porte 2 sont à zéro. La sortie Del1 du détecteur non inverseur Det1 est alors au niveau logique "0" et la sortie Start de la porte 2 au niveau logique "1".

Sur apparition d'une impulsion (passage à l'état haut) sur le signal impulsionnel d'entrée CLKIN, la sortie Start de la porte 2 passe à zéro, ce qui commande d'une part le passage à "1" du signal impulsionnel de sortie CLKOUT, en sortie de la porte 1 et d'autre part, la charge du condensateur C1. Le passage à "1" du signal impulsionnel de sortie CLKOUT commande alors la décharge du condensateur C2. Le détecteur non inverseur Det2 détecte un niveau bas en entrée et fait passer sa sortie Del2 à "0". Le signal de blocage LOCK (/Del2) est alors à "1", ce qui maintient un niveau "0" en sortie Start de la porte 2, quels que soient les états respectifs des signaux impulsionnels CLKIN et CLKOUT.

Quand apparaît un potentiel suffisant aux bornes du condensateur C1, le détecteur non inverseur Det1 détecte un niveau haut en entrée et fait passer sa sortie Del1 à "1". Ce signal de délai Del1 commande alors le passage au niveau logique "0" du signal impulsionnel de sortie CLKOUT, en sortie de la porte 1.

L'état haut du signal impulsionnel de sortie CLKOUT a donc une durée d1 parfaitement déterminée par la charge du condensateur C1.

Le passage au niveau logique "0" du signal impulsionnel de sortie CLKOUT va alors commander la charge du condensateur C2. Lorsqu'apparaît un potentiel suffisant aux bornes du condensateur, le détecteur non inverseur Det2 détecte un niveau haut et le signal de délai Del2 en sortie passe à 1.

Les signaux CLKOUT et LOCK (/Del2) sont alors tous les deux à zéro, et il est possible de prendre en compte une nouvelle impulsion sur le signal impulsionnel d'entrée CLKIN.

Ainsi, dès qu'une impulsion d'entrée CLKIN est prise en compte, le deuxième signal de délai Del2 empêche toute prise en compte d'une nouvelle impulsion, tant que le délai d1 + d2 n'est pas expiré.

On a ainsi un signal impulsionnel de sortie CLKOUT dont l'état haut a une durée d1 déterminée par le premier étage de génération de délai GD1 et dont l'état bas a une durée au minimum égale à la durée d2 déterminée par le deuxième étage de génération de délai GD2.

Dans l'exemple représenté en figure 1, le circuit de filtrage est réalisé en technologie MOS ou CMOS. Dans cet exemple, un étage de génération de délai, par exemple l'étage GD1, comporte :
- un premier transistor MOS T1 et un deuxième T2 transistor MOS T2 mis en série entre la tension d'alimentation VCC et un noeud A; la grille du premier transistor T1 est reliée au premier signal de commande Start et la grille du deuxième transistor T2 est reliée à la sortie d'un générateur GC de courant de référence.
- un troisième transistor MOS T3 est connecté entre le noeud A et la masse, sa grille étant commandée par le premier signal de commande Start;
- un condensateur C1 est connecté entre le noeud A et la masse et
- un détecteur Det1 de niveau non inverseur est connecté en entrée au noeud A et délivre en sortie le premier signal de délai Del1.

Dans l'exemple représenté, les premier et deuxième transistors sont de type P et le troisième transistor de type N.

L'étage de génération GD2 du deuxième délai a une structure semblable à celle qui vient d'être décrite, utilisant les transistors référencés T4, T5, T6 un noeud référencé B, le condensateur C2 et le détecteur de niveau non inverseur Det2, et comme signal de commande, le signal impulsionnel de sortie CLKOUT.

Le principe de fonctionnement est simple : si le premier signal de commande Start est à "1", le premier transistor P T1 (ou T4) est bloqué, ce qui bloque également le deuxième transistor P de l'étage, T2 (ou T5). Le troisième transistor N T3 (ou T6) est lui conducteur et le condensateur se décharge à travers lui. Le transistor N T3 (ou T6) est donc de préférence large de manière à laisser passer beaucoup de courant, pour une décharge rapide.

Si le premier signal de commande est à zéro, les transistors P T1 et T2 (ou T4 et T5) sont passants tandis que le transistor N T3 (ou T6) est bloqué : le condensateur se charge. Le courant de charge est de préférence commandé et fixé par un générateur GC de courant de référence GC. La structure retenue dans l'exemple de la figure 1 est une structure à miroir de courant qui permet d'imposer un courant de charge il fixe et invariant avec la tension d'alimentation.

Plus particulièrement, le générateur GC de courant de référence représenté en figure 1 pour un circuit de filtrage réalisé en technologie MOS ou CMOS, comporte un transistor MOS de référence T0 dont la grille et le drain sont connectés ensemble et reliés à la masse par une résistance de charge R, la source étant connectée à la tension d'alimentation VCC. Ce faisant, on impose un courant de référence iref dans le générateur de courant, qui est recopié, au rapport des géométries des transistors près, dans chacun des étages de génération de délai : il dans le premier étage GD1 et i2 dans le deuxième étage GD2.

Le principe du miroir de courant, bien connu, ne sera pas développé plus avant. Mais on notera que des structures plus complexes peuvent être utilisées pour le générateur de courant, comme par exemple une structure de miroir de Wilson.

Dans l'exemple représenté, le transistor de référence T0 est de type P.

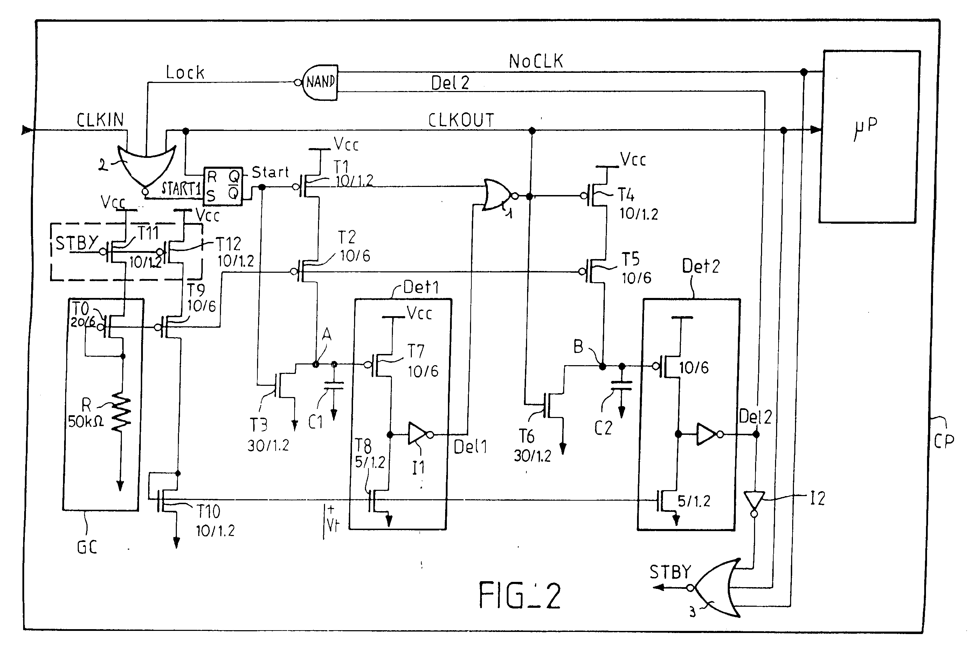

Pour améliorer les performances du circuit de filtrage décrit en référence à la figure 1, on utilisera par exemple des structures de détecteur de niveau non inverseur comme représentées sur la figure 2.

Prenons par exemple le premier détecteur de niveau Det1. Il comprendra de préférence :
- un transistor de type P T7 dont la grille est connectée au noeud A,
- un transistor de type N T8 dont la grille est polarisée à la tension de seuil Vt du transistor.
- un inverseur I1 qui sera de préférence CMOS.

Les transistors T7 et T8 sont mis en série entre VCC et la masse. L'inverseur I1 a son entrée connectée aux drains communs des transistors T7 et T8 et délivre le signal de délai Del1.

La polarisation du transistor T8 est de préférence obtenue par une branche comprenant un transistor de type P, T9, monté en miroir de courant par rapport au générateur de courant GC, c'est-à-dire avec sa grille reliée à la grille du transistor de référence T0 du générateur de courant.

Le transistor T9 est mis en série entre la tension d'alimentation VCC et la masse, avec un transistor de type N T10 monté en diode, c'est-à-dire ayant sa grille reliée à son drain. La grille du transistor T10 est de plus connectée à la grille du transistor de type N T8 du détecteur de niveau non inverseur Det1.

La même branche de polarisation sera de préférence utilisée pour le deuxième détecteur de niveau non inverseur Det2.

Le transistor de type T10 impose ainsi une tension de l'ordre de la tension de seuil d'un transistor de type N sur la grille du transistor de type N T8 qui est de ce fait, polarisé à la limite de conduction. Cette tension de polarisation de grille est rendue constante et indépendante de la tension d'alimentation VCC grâce au montage en miroir de courant du transistor T9 par rapport au transistor T0 du générateur de courant GC.

Quand le condensateur C1 est déchargé, on a un potentiel zéro sur le noeud A et le transistor P T7 du détecteur Det1 est fortement passant, ramenant un niveau de tension sur son drain proche de VCC : L'inverseur I1 délivre un zéro en sortie Del1.

Quand le condensateur C1 se charge, le transistor P T7 devient de moins en moins passant et l'inverseur T1 bascule, délivrant un niveau logique "1" en sortie Del1.

Le détecteur décrit présente un certain nombre d'avantages contribuant à la stabilité du signal Del1 qui correspond à la durée du niveau haut du signal impulsionnel de sortie CLKOUT. Les transistors T7 et T8 sont en effet polarisés par deux niveaux complètement indépendants qui sont chacun déterminés par des courants constants obtenus par utilisation d'une structure à miroir de courant. Mais d'autres types de détecteur peuvent être utilisés.

Dans un premier perfectionnement représenté sur la figure 2, une bascule RS est placée entre la sortie de la porte logique 2 et les générateurs de délai. Cette bascule RS reçoit sur son entrée S le signal de sortie, référencé ici Start1, de la porte 2 et elle reçoit sur son entrée de remise à zéro (R), le signal impulsionnel de sortie CLKOUT. Il délivre sur une sortie Q, le premier signal de commande Start. Sur cette figure, la sortie de la porte 2 est référencée Start1.

L'intérêt d'une telle bascule RS est de permettre de ne pas prendre en compte une nouvelle impulsion CLKIN dès que le signal de blocage LOCK (/Del2) est repassé à zéro, si l'intervalle entre le moment où le signal LOCK (/Del2) est repassé à zéro et donc le signal de sortie Start 1 de la porte 2 repassé à "1" et le moment où une nouvelle impulsion CLKIN apparaît, est insuffisant pour permettre une décharge complète du condensateur C1.

En effet, si la décharge est incomplète, la charge du condensateur démarre alors que le potentiel en A est déjà supérieur à zéro et le délai d1 sera diminué.

En utilisant une bascule RS, si l'impulsion sur le signal de sortie Start1 est trop courte, la bascule ne la verra pas et le signal Start en sortie de la bascule restera à zéro. La bascule RS est remise à zéro par le passage à l'état haut, du signal impulsionnel de sortie CLKOUT, c'est-à-dire à chaque fois qu'une impulsion CLKIN est prise en compte.

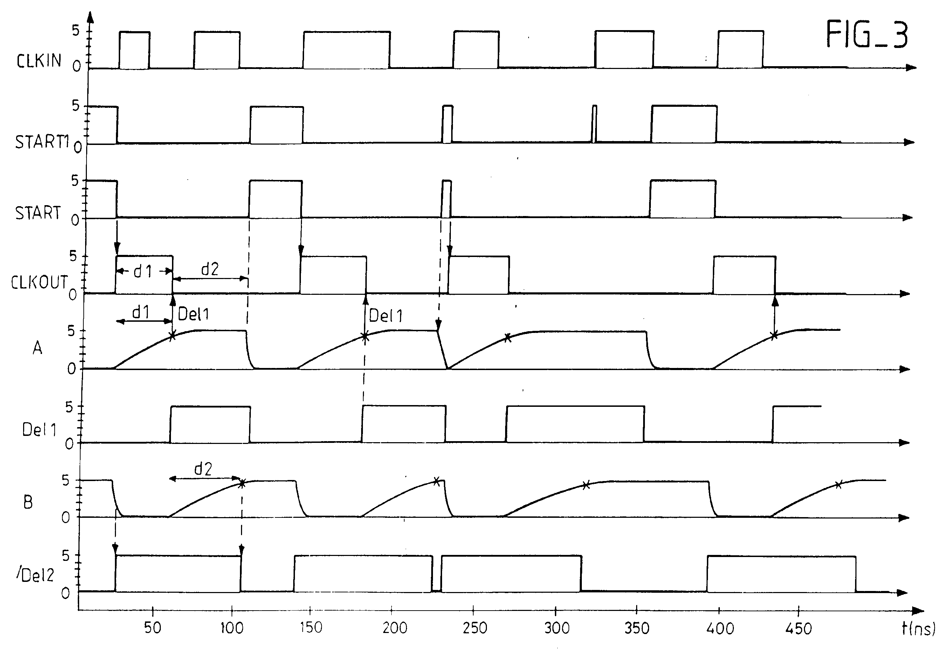

Le chronogramme représenté en figure 3 montre clairement le cas de figure où une impulsion CLKIN ne sera pas prise en compte, du fait de la bascule RS.

Le circuit de filtrage décrit sera avantageusement compris dans un circuit intégré de type carte à puce CP (figure 2) comprenant un microprocesseur µP par exemple.

Pour limiter la consommation du circuit de filtrage, on peut prévoir que le microprocesseur délivre un signal NOCLK indiquant qu'il n'a pas besoin du signal impulsionnel de sortie CLKOUT, auquel cas, il est inutile de filtrer le signal impulsionnel d'entrée CLKIN.

Ce signal NOCLK sera alors avantageusement utilisé pour inhiber le générateur de courant GC et pour empêcher la prise en compte de toute impulsion sur le signal impulsionnel d'entrée CLKIN.

Pour le générateur de courant, on utilisera par exemple tout simplement un transistor MOS T11 en série entre VCC et le transistor T0 et commandé sur sa grille par un signal de commutation STBY. Un transistor MOS T12 sera de la même manière placé en série entre VCC et le transistor T9 de la branche de polarisation des détecteurs Det1 et Det2.

Dans l'exemple de la figure 2, les transistors T11 et T12 sont de type P.

On prend comme hypothèse que le signal NOCLK est actif à l'état bas. Dans ce cas le signal STBY sera par exemple délivré par une troisième porte NON OU 3 recevant en entrée les signaux NOCLK, CLKOUT et /Del2. En effet, il faut attendre, si une impulsion CLKOUT est en train d'être générée, que cette impulsion soit complètement générée : il faut donc attendre que le signal impulsionnel CLKOUT soit à zéro et que le signal de délai Del2 soit à 1, (ou /Del2 à zéro). On peut alors prendre en compte le signal d'inhibition NOCLK : le signal de sortie STBY prend alors un niveau "1" et les transistors T11 et T12 de type P sont bloqués, empêchant la génération de tout courant dans les transistors T0 et T9.

Il faut aussi inhiber les circuits générateurs de délai GD1 et GD2, en empêchant le signal Start de passer à zéro. Il suffit pour cela de forcer le signal /Del2 à "1", pour forcer la sortie de la porte 2 à "1". Dans l'exemple une porte NAND est utilisée recevant en entrée les signaux Del2 et NOCLK et délivrant en sortie un signal Lock, égal à /Del2 quand NOCLK est à "1" et de niveau "0" quand NOCLK est à "0".

Le circuit de filtrage selon l'invention est particulièrement fiable et permet de filtrer les impulsions parasites sur le signal impulsionnel d'entrée.

Sa fiabilité est améliorée par l'utilisation de structures à miroir de courant comme générateurs de courant. Il est entièrement réalisable sous forme intégrée et ne nécessite aucun composant discret.

La résistance R du générateur de courant sera par exemple réalisée en diffusion et les condensateurs par capa-implant, c'est-à-dire par une diffusion non auto-alignée recouverte par un oxyde de grille.

Un exemple de valeurs numériques pour les géométries des transistors, la résistance et les condensateurs est donné sur la figure 2.

## Revendications

1. Circuit de filtrage d'un signal impulsionnel d'entrée comportant :
- un étage de génération (GD1) d'un premier délai d1 comprenant un premier condensateur (C1) dont la charge et la décharge sont contrôlées par un premier signal de commande (Start), l'une des bornes du premier condensateur étant connectée à un premier détecteur non inverseur (Det1) pour délivrer un premier signal de délai (Del1), l'autre borne étant connectée à la masse;
- un étage de génération (GD2) d'un deuxième délai d2 comprenant un deuxième condensateur (C2) dont la charge et la décharge sont contrôlées par un deuxième signal de commande (CLKOUT), l'une des bornes du deuxième condensateur étant connectée à un deuxième détecteur non inverseur (Det2) pour délivrer un deuxième signal de délai (Del2), l'autre borne étant connectée à la masse ;
- une première porte NON OU (1) recevant en entrée le premier signal de commande (Start) et le premier signal de retard (Del1) et délivrant en sortie le deuxième signal de commande CLKOUT qui est le signal impulsionnel de sortie;
- une deuxième porte NON OU (2) recevant en entrée le signal impulsionnel d'entrée (CLKIN), le signal impulsionnel de sortie (CLKOUT) et un signal de blocage (LOCK) commandé par le deuxième signal de délai (Del2) et délivrant en sortie le premier signal de commande (Start);
pour délivrer en sortie des impulsions de largeur de la durée du premier délai (d1) et espacées au minimum de la durée du deuxième délai (d2).

2. Circuit de filtrage selon la revendication 1, caractérisé en ce qu'une bascule de type RS a son entrée connectée à la sortie (Start1) de la deuxième porte NON OU (2) et délivre sur une sortie (Q) le premier signal de commande (Start), son entrée de remise à zéro étant commandée par le deuxième signal de commande (CLKOUT).

3. Circuit de filtrage selon la revendication 1 ou 2, caractérisé en ce que le signal de blocage est délivré par un inverseur (I1) recevant en entrée le deuxième signal de délai (Del2).

4. Circuit de filtrage selon la revendication 1 ou 2, caractérisé en ce que la charge des condensateurs se fait à courant constant commandé par un générateur de courant (GC) à miroir de courant.

5. Circuit de filtrage selon la revendication 3, caractérisé en ce qu'un étage de génération d'un délai (GD1) qui est commandé par un signal de commande (Start) et qui comprend un condensateur, comporte en outre :
- un premier transistor MOS (T1) et un deuxième transistor MOS (T2) mis en série entre la tension d'alimentation VCC et un noeud (A), la grille du premier transistor (T1) étant commandée par le signal de commande (Start), la grille du deuxième transistor étant commandée par une sortie du générateur de courant (GC);
- un troisième transistor MOS (T3) connecté entre le noeud (A) et la masse, sa grille étant commandée par le signal de commande (Start);
le condensateur (C1) étant connecté entre le noeud (A) et la masse.

6. Circuit de filtrage selon la revendication 3 ou 4, caractérisé en ce que le générateur de courant comprend un transistor MOS (T0) de référence ayant sa grille et son drain reliés ensemble, mis en série avec une charge résistive (R) entre la tension d'alimentation (VCC) et la masse, la sortie du générateur de courant étant prise au drain du transistor.

7. Circuit intégré à microprocesseur comportant un circuit de filtrage selon l'une des revendications 1 à 6, caractérisé en ce que le microprocesseur reçoit en entrée le signal impulsionnel de sortie (CLKOUT), et délivre en sortie un signal d'utilisation (NOCLK) de ce signal impulsionnel de sortie, le circuit intégré comportant en outre une circuiterie d'inhibition du circuit de filtrage, la circuiterie d'inhibition étant commandée par le signal d'inhibition (NOCLK).

8. Circuit intégré selon la revendication 7, caractérisé en ce que la circuiterie d'inhibition comprend une porte logique pour inhiber les circuits de génération de délai, cette porte logique recevant en entrée le signal d'inhibition (NOCLK) et le deuxième signal de délai (Del2) et délivrant en sortie le signal de blocage LOCK.

9. Circuit intégré selon la revendication 7, caractérisé en ce que la circuiterie d'inhibition comprend un circuit logique pour inhiber le générateur de courant, ce circuit comportant :
- un transistor de commutation (T11) placé en série entre la tension d'alimentation VCC et le transistor de référence (T0) du générateur de courant, et commandé sur sa grille par la sortie d'une porte NON/ET recevant en entrée le signal d'inhibition (NOCLK), le signal impulsionnel de sortie (CLKOUT) et le deuxième signal de délai inversé (/Del2).

## Claims

1. Circuit for filtering an input pulse signal having:
- a stage (GD1) for generating a first delay d1 comprising a first capacitor (C1) whose charging and discharging are controlled by a first control signal (Start), one of the terminals of the first capacitor being connected to a first non-inverting detector (Det1) for delivering a first delay signal (Del1), the other terminal being connected to earth;
- a stage (GD2) for generating a second delay d2 comprising a second capacitor (C2) whose charging and discharging are controlled by a second control signal (CLKOUT), one of the terminals of the second capacitor being connected to a second non-inverting detector (Det2) for delivering a second delay signal (Del2), the other terminal being connected to earth;
- a first NOR gate (1) receiving as an input the first control signal (Start) and the first delay (Dell) and delivering as an output the second control signal (CLKOUT) which is the output pulse signal;
- a second NOR gate (2) receiving as an input the input pulse signal (CLKIN), the output pulse signal (CLKOUT) and a locking signal (LOCK) controlled by the second delay signal (Del2) and delivering as an output the first control signal (Start);
in order to deliver as an output pulses with the same width as the duration of the first delay (d1) and spaced apart at a minimum by the duration of the second delay (d2).

2. Filtering circuit according to Claim 1, characterised in that an RS flip-flop has its input connected to the output (Start1) of the second NOR gate (2) and delivers the first control signal (Start) at an output (Q), its zeroing input being controlled by the second control signal (CLKOUT).

3. Filtering circuit according to Claim 1 or 2, characterised in that the locking signal is delivered by an inverter (I1) receiving the second delay signal (Del2) as an input.

4. Filtering circuit according to Claim 1 or 2, characterised in that the charging of the condensers takes place at constant current controlled by a current generator (GC) with a current mirror.

5. Filtering circuit according to Claim 3, characterised in that a delay generating stage (GD1) which is controlled by a control signal (Start) and which comprises a capacitor, also has:
- a first MOS transistor (T1) and a second MOS transistor (T2) put in series between the supply voltage VCC and a node (A), the gate of the first transistor (T1) being controlled by the control signal (Start), the gate of the second transistor being controlled by an output of the current generator (GC);
- a third MOS transistor (T3) connected between the node (A) and earth, its gate being controlled by the control signal (Start);
the capacitor (C1) being connected between the node (A) and earth.

6. Filtering circuit according to Claim 3 or 4, characterised in that the current generator comprises a reference MOS transistor (T0) with its gate and drain connected together, put in series with a resistive load (R) between the supply voltage (VCC) and earth, the output of the current generator being taken to the drain of the transistor.

7. Integrated circuit with a microprocessor having a filtering circuit according to one of Claims 1 to 6, characterised in that the microprocessor receives the output pulse signal (CLKOUT) as an input, and delivers as an output a signal (NOCLK) for using this output pulse signal, the integrated circuit also having circuitry for inhibiting the filtering circuit, the inhibition circuitry being controlled by the inhibition signal (NOCLK).

8. Integrated circuit according to Claim 7, characterised in that the inhibition circuitry comprises a logic gate for inhibiting the delay generating circuits, this logic gate receiving as an input the inhibition signal (NOCLK) and the second delay signal (Del2) and delivering the locking signal (LOCK) as an output.

9. Integrated circuit according to Claim 7, characterised in that the inhibition circuitry comprises a logic circuit for inhibiting the current generator, this circuit having:
- a switching transistor (T11) placed in series between the supply voltage VCC and the reference transistor (T0) of the current generator, and controlled at its gate by the output of a NAND gate receiving as an input the inhibition signal (NOCLK), the output pulse signal (CLKOUT) and the second inverted delay signal (/Del2).

## Patentansprüche

1. Eingangsimpulssignalfilterschaltkreis mit:
- einer Generatorstufe (GD1) für eine erste Verzögerung (d1) mit einem ersten Kondensator (C1), dessen Aufladung und Entladung durch ein erstes Steuersignal (Start) gesteuert wird, wobei einer der Anschlüsse des ersten Kondensators mit einem ersten nichtinvertierenden Detektor (Det1) verbunden ist, um ein erstes Verzögerungssignal (Del1) auszugeben, und der andere Anschluß mit Masse verbunden ist;
- einer Generatorstufe (GD2) für eine zweite Verzögerung (d2) mit einem zweiten Kondensator (C2), dessen Aufladung und Entladung durch ein zweites Steuersignal (CLKOUT) gesteuert wird, wobei einer der Anschlüsse des zweiten Kondensators mit einem zweiten nichtinvertierenden Detektor (Det2) verbunden ist, um ein zweites Verzögerungssignal (Del2) auszugeben, und der andere Anschluß mit Masse verbunden ist;
- einem ersten NICHT-ODER-Gatter (1), an dessen Eingang das erste Steuersignal (Start) und das erste Verzögerungssignal (Del1) anliegt und das am Ausgang das zweite Steuersignal (CLKOUT) ausgibt, das das Ausgangsimpulssignal ist;
- einem zweiten NICHT-ODER-Gatter (2), an dessen Eingang das Eingangsimpulssignal (CLKIN), das Ausgangsimpulssignal (CLKOUT) und ein Sperrsignal (LOCK) anliegt, das durch das zweite Verzögerungssignal (Del2) gesteuert wird und das am Ausgang das erste Steuersignal (Start) ausgibt; um am Ausgang Impulse mit einer Breite, die der Dauer der ersten Verzögerung (d1) entspricht, und mit einem Abstand, der mindestens der Dauer der zweiten Verzögerung (d2) entspricht, auszugeben.

2. Filterschaltkreis nach Anspruch 1,
dadurch gekennzeichnet,daß eine RS-Kippstufe über ihren Eingang mit dem Ausgang (Start1) des zweiten NICHT-ODER-Gatters (2) verbunden ist und am Ausgang (Q) das erste Steuersignal (Start) ausgibt, wobei ihr Reset-Eingang gesteuert wird durch das zweite Steuersignal (CLKOUT).

3. Filterschaltkreis nach Anspruch 1 oder 2,
dadurch gekennzeichnet,
daß das Sperrsignal durch einen Inverter (I1) ausgegeben wird, an dessen Eingang das zweite Verzögerungssignal (Del2) anliegt.

4. Filterschaltkreis nach Anspruch 1 oder 2,
dadurch gekennzeichnet,
daß die Aufladung von Kondensatoren mit Gleichstrom erfolgt, gesteuert durch einen Stromgenerator (GC) als Stromspiegel.

5. Filterschaltkreis nach Anspruch 3,
dadurch gekennzeichnet,
daß eine Verzögerungsgeneratorstufe (GD1) durch ein Steuersignal (Start) gesteuert wird und einen Kondensator umfaßt, sowie außerdem:
- einen ersten MOS-Transistor (T1) und einen zweiten MOS-Transistor (T2) in Reihe zwischen den Versorgungsspannung VCC und einem Knoten (A), wobei das Gate des ersten Transistors (T1) gesteuert wird durch das Steuersignal (Start), das Gate des zweiten Transistors gesteuert wird durch einen Ausgang des Stromgenerators (GC);
- einen dritten MOS-Transistor (T3) zwischen dem Knoten (A) und Masse, dessen Gate gesteuert wird durch das Steuersignal (Start);
wobei der Kondensator (C1) zwischen den Knoten (A) und Masse geschaltet ist.

6. Filterschaltkreis nach Anspruch 3 oder 4,
dadurch gekennzeichnet,
daß der Stromgenerator einen MOS-Referenztransistor(T0) umfaßt, dessen Gate und Drain zusammengeschlossen sind und der in Reihe mit einer Widerstandslast (R) zwischen die Versorgungsspannung (VCC) und Masse geschaltet ist wobei der Ausgang des Stromgenerators vom Drain des Transistors abgenommen wird.

7. Integrierte Mikroprozessorschaltkreis mit einer Filterschaltkreis nach einem der Ansprüche 1 bis 6,
dadurch gekennzeichnet,
daß der Mikroprozessor am Eingang das Ausgangsimpulssignal (CLKOUT) empfängt und am Ausgang ein Verwendungssignal (NOCLK) dieses Ausgangsimpulssignals ausgibt, wobei der integrierte Schaltkreis außerdem einen Inhibitor-Schaltkreis für den Filterschaltkreis umfaßt, wobei der Inhibitor-Schaltkreis gesteuert wird durch das Inhibitor-Signal (NOCLK).

8. Integrierter Schaltkreis nach Anspruch 7,
dadurch gekennzeichnet,
daß der Inhibitor-Schaltkreis ein Logik-Gatter zum Inhibieren des Verzögerungsgeneratorschaltkreises umfaßt, wobei dieses Logik-Gatter am Eingang das Inhibitor-Signal (NOCLK) und das zweite Verzögerungssignal (Del2) empfängt und am Ausgang das Sperrsignal LOCK ausgibt.

9. Integrierter Schaltkreis nach Anspruch 7,
dadurch gekennzeichnet,
daß der Inhibitor-Schaltkreis einen Logik-Schaltkreis zum Inhibieren des Stromgenerators umfaßt, wobei dieser Schaltkreis umfaßt:
- einen Schalttransistor (T11) in Reihe zwischen der Versorgungsspannung (VCC) und dem Referenztransistor (T0) des Stromgenerators, der über sein Gate durch den Ausgang eines NICHT-UND-Gatters gesteuert wird, das am Eingang das Inhibitor-Signal (NOCLK), das Ausgangsimpulssignal (CLKOUT) und das zweite invertierte Verzögerungssignal (/Del2) empfängt.
